# FASCICULE DE BREVET EUROPEEN

(11) **EP 3 545 621 B1**
(45) Date de publication et mention de la délivrance du brevet: **11.11.2020**
(21) Numéro de dépôt: 17811652.1
(22) Date de dépôt: 22.11.2017
(51) Int. Cl.: H03K 3/037, H03K 17/687

(54) **DISPOSITIF DE COMMUTATION D'UN CIRCUIT DE PUISSANCE**
SCHALTELEMENT FÜR EINE LEISTUNGSSCHALTUNG
SWITCHING DEVICE OF A POWER CIRCUIT

(30) Priorité: 25.11.2016 FR 1661533; 02.02.2017 FR 1750867
(43) Date de publication de la demande: 02.10.2019
(73) Titulaire: Exagan, 38040 Grenoble Cedex 9 (FR)
(72) Inventeur: GUILLOT, Laurent, 31600 Seysses (FR); SUTTO, Thierry, 31600 Seysses (FR); MOREAU, Eric, 31470 Frouzins (FR)
(74) Mandataire: IP Trust
(86) Numéro de dépôt international: PCT/FR2017/053208
(87) Numéro de publication internationale: WO 2018/096265

(56) Documents cités:
- DE-B3-102006 029 928
- DE-B3-102010 027 832
- US-A1- 2007 170 897

## Description

### DOMAINE DE L'INVENTION

La présente invention concerne un dispositif de commutation d'un circuit de puissance à double commande, comprenant un transistor haute tension en série avec un transistor basse tension.

### ARRIERE PLAN TECHNOLOGIQUE DE L'INVENTION

Le document « A dual-mode Driver IC with Monolithic Negative Drive-Voltage Capability and Digigtal Current-Mode Controller for Depletion-Mode GaN HEMT » (Yue Wen et Al, IEEE Transaction on Power Electronic, 2016) décrit notamment un dispositif de commutation comprenant un transistor haute tension en mode déplétion en série avec un transistor basse tension en mode enrichissement, chaque transistor étant commandé séparément.

Le dispositif comprend une première borne, pour recevoir un signal de commutation, électriquement reliée, par l'intermédiaire d'un circuit d'attaque, à la grille du transistor haute tension en mode déplétion. L'état bloquant du transistor haute tension en mode déplétion est obtenu en appliquant une tension négative, inférieure à sa tension seuil, entre la grille et la source de ce transistor. Cette tension négative pouvant ne pas être disponible, par exemple au démarrage du dispositif de commutation ou lorsqu'il fonctionne en mode dégradé, le dispositif est muni d'un transistor basse tension en mode enrichissement, monté en série avec le transistor haute tension.

Le dispositif de commutation de l'état de la technique comprend également une deuxième borne pour recevoir un signal de commande, la deuxième borne étant électriquement reliée à la grille du transistor basse tension. Le signal de commande permet de rendre bloquant le transistor basse tension et de contrôler l'état ouvert du dispositif de commutation, même en l'absence d'une tension négative appliquée à la grille du transistor haute tension.

En contrôlant séparément, en « double commande » chacun des transistors haute et basse tension mis en série, il est donc possible de définir l'état ouvert ou fermé du circuit de commutation. Un tel circuit est aussi décrit dans le document DE 10 2010 027832 B3.

Rappelons qu'un dispositif de commutation peut présenter un mode de fonctionnement « actif » qui correspond au mode de fonctionnement « normal » dans lequel l'état ouvert ou fermé du dispositif est contrôlé par le signal de commutation. Il peut également présenter un mode de fonctionnement « inactif » qui correspond au mode « basse consommation » (dispositif en sommeil) ou de mise en service du dispositif (démarrage du mode de fonctionnement « actif »).

Dans ce mode de fonctionnement « inactif », le dispositif de commutation est à l'état ouvert et les différents éléments actifs du dispositif ne sont pas alimentés électriquement. C'est le cas notamment du circuit d'attaque connecté à la grille du transistor haute tension. En l'absence d'alimentation électrique, ce circuit présente une sortie en haute impédance, la tension qui s'applique sur la grille du transistor haute tension est alors flottante et non contrôlée. Une éventuelle surtension s'appliquant sur le drain du transistor haute tension peut alors, par effet de couplage entre le drain et la grille, maintenir ou rendre le transistor haute tension passant malgré la désactivation du dispositif de commutation. Dans ce cas, toute la tension commutée s'applique aux bornes du transistor basse tension. Cette tension peut être importante, par exemple supérieure à 600 V, et excéder la tension d'avalanche que peut supporter ce transistor, menant ainsi à l'endommagement du dispositif.

Par ailleurs, le passage d'un mode de fonctionnement à un autre peut entrainer l'apparition de tensions transitoires ou de chemins de courants transitoires entre les bornes de commutation du dispositif. Ces tensions ou ces courants sont susceptibles d'endommager le transistor haute tension ou le transistor basse tension, si le passage d'un mode de fonctionnement à un autre n'est pas parfaitement contrôlé.

D'une manière plus générale, il est souhaitable de disposer d'un circuit d'attaque qui puisse être configuré pour être parfaitement ajusté aux autres éléments du circuit et à son environnement afin de limiter les conséquences des phénomènes transitoires pouvant apparaître lors du passage d'un mode de fonctionnement à un autre, ou lors du fonctionnement du dispositif.

### OBJET DE L'INVENTION

La présente invention vise à remédier, au moins en partie, à l'un au moins des problèmes évoqués. Elle vise notamment à fournir un dispositif de commutation qui puisse sélectivement passer d'un mode inactif à un mode actif (et inversement) sans endommager les transistors qui le composent. Elle vise en général à fournir un dispositif de commutation dont le fonctionnement limite les risques d'endommagement des transistors qui le composent, en mode actif, inactif ou lors des phases transitoires de passage d'un mode à l'autre.

### BREVE DESCRIPTION DE L'INVENTION

En vue de la réalisation de l'un de ces buts, l'objet de l'invention propose, dans son acceptation la plus large, un dispositif de commutation d'un circuit de puissance comprenant :
- deux bornes de commutation ;
- un transistor haute tension en mode déplétion et un transistor basse tension en mode enrichissement, disposés en série entre les deux bornes de commutation ; un circuit de commande présentant une première entrée pour recevoir un signal de commutation et une seconde entrée pour recevoir un signal d'activation du dispositif. Le circuit de commande est configuré pour placer le dispositif de commutation :
   - dans un état inactif, lorsque le signal d'activation présente un premier niveau, dans lequel le transistor basse tension et le transistor haute tension sont chacun rendus bloquants ; et
   - dans un état actif lorsque le signal d'activation présente un second niveau différent du premier, dans lequel le transistor basse tension est rendu passant et le signal de commutation appliqué à la grille du transistor haute tension.
- un circuit d'attaque pour appliquer le signal de commutation à la grille du transistor haute tension, le circuit d'attaque étant alimenté avec une première tension issue d'une première source de tension et avec une deuxième tension issue d'une deuxième source de tension, la première et la deuxième tension étant respectivement supérieure et inférieure à la tension de seuil du transistor haute tension ;
- au moins un module de programmation associé au circuit d'attaque (4), ce dernier étant configuré pour permettre une programmation du courant entrant (I⁺), destiné à être injecté à la grille du transistor haute tension (5), et du courant sortant (I⁻), destiné à être tiré de ladite grille ; le module de programmation étant respectivement connectable à un premier et un second composant passif, pour programmer respectivement le courant entrant (I⁺) et le courant sortant (I⁻).

Selon d'autres caractéristiques avantageuses et non limitatives de l'invention, prises seules ou selon toute combinaison techniquement réalisable :
- le au moins un module de programmation (15a, 15'a, 15b, 15'b) est compris dans le circuit d'attaque (4) ;
- le au moins un module de programmation (15a, 15'a, 15b, 15'b) est extérieur au circuit d'attaque (4) et connecté à celui-ci ;
- le dispositif de commutation comprend deux modules de programmation (15a, 15'a, 15b, 15'b), l'un connectable au premier composant passif et destiné à programmer le courant entrant (I⁺), et l'autre connectable au second composant passif et destiné à programmer le courant sortant (I⁻) ;
- le premier composant passif et le second composant passif sont des résistances (Rₒₙ, R_{off}) ;
- les première et deuxième sources de tension sont programmables ;
- le dispositif comprend un module générateur de signaux transitoires connecté au circuit d'attaque, configuré pour contrôler l'évolution transitoire du courant de grille entrant et sortant au niveau de la grille du transistor haute tension.

L'invention concerne également un procédé de commande d'un dispositif de commutation, le dispositif de commutation comprenant :
- deux bornes de commutation ;
- un transistor haute tension et un transistor basse tension en mode enrichissement disposés en série entre les deux bornes de commutation ;
- un circuit de commande présentant une première entrée pour recevoir un signal de commutation et une seconde entrée pour recevoir un signal d'activation du dispositif ;

Le procédé place de manière contrôlée le dispositif de commutation :
- dans un état inactif, lorsque le signal d'activation présente un premier niveau, dans lequel le transistor basse tension et le transistor haute tension sont chacun commandés bloqués ; et
- dans un état actif, lorsque le signal d'activation présente un second niveau différent du premier, dans lequel le transistor basse tension est commandé passant et le signal de commutation appliqué à la grille du transistor haute tension.

Selon d'autres caractéristiques avantageuses et non limitatives de l'invention, prises seules ou selon toute combinaison techniquement réalisable :
- le dispositif de commutation comprend des composants actifs électriquement alimentés par des sources de tension et dans lequel, dans l'état inactif, une partie au moins des sources de tension sont éteintes ;
- le passage de l'état inactif à l'état actif comprend l'établissement de première et deuxième sources de tension ;
- l'établissement des première et deuxième sources de tension comprend la programmation des niveaux de tensions appliquées à la grille du transistor haute tension, pour le commander passant ou bloquant ;
- l'établissement des première et deuxième sources de tension comprend la détermination de l'intensité des courants respectivement injectés ou tirés au niveau de la grille du transistor haute tension, pour le commander passant ou bloquant ;
- le passage de l'état inactif à l'état actif est réalisé uniquement si les tensions des première et deuxième sources de tensions sont correctement établies ;
- le passage de l'état actif à l'état inactif comprend une première étape dans laquelle le transistor haute tension est commandé à l'état bloqué ;
- le passage de l'état actif à l'état inactif comprend une deuxième étape, postérieure à la première, dans laquelle le transistor basse tension est commandé à l'état bloqué ;
- le passage de l'état actif à l'état inactif comprend une troisième étape, postérieure à la deuxième, dans laquelle une partie au moins des sources de tension d'alimentation électrique des éléments actifs du dispositif de commutation est commandée pour s'éteindre.

### BREVE DESCRIPTION DES DESSINS

D'autres caractéristiques et avantages de l'invention ressortiront de la description détaillée de l'invention qui va suivre en référence aux figures annexées sur lesquels :
- La figure 1 représente un dispositif de commutation conforme à l'invention ;
- la figure 2 représente le schéma de transition entre un mode actif et un mode inactif d'un dispositif de commutation conforme à l'invention ;
- la figure 3 représente un exemple particulier de mise en œuvre de l'invention ;
- les figures 4a, 4b et 4c représentent des schémas fonctionnels d'une partie du dispositif de commutation selon des modes de réalisation particuliers de l'invention ;
- la figure 5 représente un schéma fonctionnel d'une partie du dispositif de commutation selon un autre mode de réalisation particulier de l'invention ;
- la figure 6 présente un exemple de diagramme d'évolution temporelle du courant de grille du transistor haute tension.

### DESCRIPTION DETAILLEE DE L'INVENTION

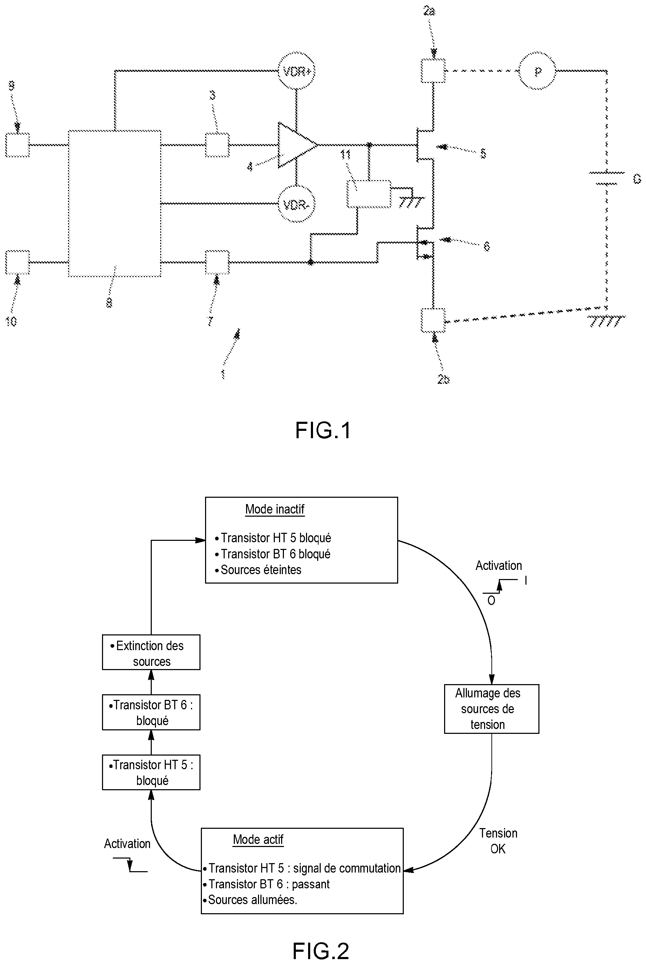

La figure 1 représente un dispositif de commutation 1 conforme à l'invention. On a représenté en pointillés sur cette figure une charge P et un générateur G composant un circuit de puissance connecté à deux bornes de commutation 2a, 2b du dispositif 1.

Le générateur G peut présenter une tension importante, par exemple de 600 V ou plus, et le courant circulant dans le circuit de puissance et dans le dispositif de commutation 1 peut être de forte intensité, par exemple supérieur à 1 A. Le dispositif de commutation 1, comme cela est bien connu en soi, permet de sélectivement appliquer la tension du générateur G à la charge P. Il agit donc comme un interrupteur de puissance, commandé par un signal de commutation de relativement faible amplitude, de l'ordre de quelques volts.

Le dispositif de commutation 1 comprend une première borne 3 pour recevoir ce signal de commutation. Cette première borne 3 est électriquement reliée par l'intermédiaire d'un circuit d'attaque 4 à une grille d'un transistor haute tension 5.

Pour lever toute ambiguïté, les termes « électriquement connecté » ou « électriquement relié » de la présente description sont utilisés pour indiquer que deux éléments sont directement ou indirectement connectés entre eux.

Par « transistor haute tension », on désigne un transistor comprenant un drain, une source et une grille, la tension de faible amplitude appliquée sur la grille (de l'ordre de quelques volts) permettant de rendre électriquement passant ou bloquant la liaison entre le drain et la source. À l'état bloqué, la tension se développant entre le drain et la source peut être de forte amplitude, par exemple de 600 V ou plus, sans endommager le transistor.

Un transistor haute tension en mode déplétion (D-mode) présente une tension seuil négative (typiquement comprise entre -6V et -2V). La tension entre la grille et la source doit donc être négative, inférieure à cette tension seuil, pour rendre bloquant ce transistor. Le dispositif de commutation selon l'invention est particulièrement avantageux dans le cas d'un transistor haute tension D-mode pour contrôler l'état ouvert du dispositif de commutation, même en l'absence d'une tension négative appliquée à la grille dudit transistor haute tension, par exemple au démarrage du dispositif de commutation.

Le transistor à haute tension peut être un transistor HEMT par exemple à base de GaN ou de SiC. Ce type de transistor présente une tension d'avalanche (c'est-à-dire la tension maximale applicable entre le drain et la source du transistor sans qu'il soit endommagé, il peut s'agir d'une tension de claquage) de forte amplitude, choisie pour être supérieure à la tension du générateur du circuit de puissance, par exemple de plus de 600V.

En mode de fonctionnement normal ou actif du dispositif de commutation, la source du transistor haute tension est à 0 V. Pour permettre la commande du transistor haute tension à l'état bloquant ou à l'état passant selon la nature du signal de commutation, le circuit d'attaque 4 est relié à une première source de tension VDR+ et à une deuxième source de tension VDR-. Le circuit d'attaque est alimenté avec une première tension, issue de la première source VDR+, dont la grandeur est supérieure à la tension de seuil du transistor haute tension. Il peut par exemple s'agir d'une tension de 2 V, dans le cas d'un transistor haute tension D-mode. Le circuit d'attaque est également alimenté avec une deuxième tension, issue de la deuxième source VDR-, dont la grandeur est inférieure à la tension de seuil du transistor haute tension. Il peut s'agir par exemple d'une tension de -8 V, dans le cas d'un transistor haute tension D-mode. Selon la valeur du signal de commutation appliquée à la première borne d'entrée 3, la première tension ou la deuxième tension est appliquée à la grille du transistor haute tension permettant sélectivement de le rendre passant ou bloquant.

Poursuivant la description du dispositif de commutation 1 de la figure 1, le transistor haute tension 5 est disposé en série avec un transistor basse tension 6 entre les deux bornes de commutations 2a, 2b. En d'autres termes, le drain du transistor haute tension 5 est électriquement relié à une des deux bornes de commutation 2a, la source du transistor haute tension 5 est reliée au drain du transistor basse tension 6, et la source du transistor basse tension 6 est reliée à l'autre des deux bornes de commutations 2b.

Le transistor basse tension est avantageusement un transistor en mode enrichissement, présentant une tension seuil positive. La tension entre la grille et la source doit donc être positive et supérieure à cette tension seuil, pour rendre passant ce transistor. On comprendra dans le cadre de la présente invention que la tension d'avalanche du transistor basse tension 6 est inférieure à la tension d'avalanche du transistor haute tension 5.

Le transistor basse tension peut-être un transistor MOSFET à base de silicium. La tension d'avalanche du transistor basse tension est inférieure à celle du transistor haute tension. Elle peut être par exemple de l'ordre de 30 V.

Une seconde borne 7 du dispositif de commutation 1 est reliée à la grille du transistor basse tension 6. Cette seconde borne 7 est prévue pour recevoir un signal de commande.

Comme cela ressort du schéma de principe de la figure 1, un signal de commande, correspondant à une tension positive et supérieure à la tension seuil du transistor basse tension 6, appliqué sur la seconde borne 7, rend le transistor basse tension 6 passant, la source du transistor basse tension 6 étant reliée à la masse du circuit. Dans ce premier mode de fonctionnement (qui correspond à l'état de fonctionnement actif normal du dispositif 1), l'état ouvert ou fermé du dispositif de commutation 1 est dicté par le signal de commutation appliqué sur la première borne 3 ; en effet ; le signal de commutation, via le circuit d'attaque 4, peut faire sélectivement passer, le transistor haute tension 5 en mode passant ou bloqué.

Au contraire, lorsque le signal de commande présentant une tension inférieure à la tension seuil du transistor basse tension 6 est appliqué sur la seconde borne 7, le transistor basse tension 6 est placé dans un mode bloqué. Dans ce mode de fonctionnement inactif, le dispositif de commutation 1 est à l'état ouvert, quelle que soit la valeur du signal de commutation appliquée sur la première borne d'entrée 3. On rappelle que lorsque le dispositif 1 est dans cet état ouvert, le signal de commande présentant une tension inférieure à la tension seuil du transistor basse tension, le drain de ce transistor présente une tension flottante qui, tirée par le courant de fuite du transistor haute tension, s'établit à la tension d'avalanche du transistor basse tension, qui comme on l'a mentionné précédemment peut être de 30V.

Le dispositif de commutation 1 comprend également un circuit de commande 8 pour élaborer le signal de commande et/ou transmettre le signal de commutation, selon le mode de fonctionnement actif ou inactif du dispositif de commutation 1. Le circuit de commande 8 comprend deux sorties, respectivement connectées électriquement à la première borne 3 et à la seconde borne 7. Le circuit de commande 8 comprend également une première entrée 9 pour recevoir le signal de commutation et une seconde entrée 10 pour recevoir un signal d'activation du dispositif 1.

Pour permettre au circuit de commande 8 de contrôler la mise en fonctionnement, l'extinction et vérifier le bon fonctionnement des sources de tension VDR+, VDR-, le circuit de commande 8 est relié à ces sources d'alimentation électrique par des liaisons électriques (illustrées sur la figure 1).

Selon un aspect de l'invention, le circuit de commande 8 forme une machine d'état permettant de placer le dispositif 1 dans l'un des modes de fonctionnement « actif » ou « inactif » et de contrôler la transition entre ces modes en toute sécurité. Le circuit de commande 8 peut être réalisé sous forme intégrée, par exemple sous la forme d'un système de portes logiques programmable, ou sous la forme de composants discrets, voire même sous la forme d'un microcontrôleur convenablement programmé pour reproduire le comportement détaillé ci-dessous.

Le circuit de commande 8 est électriquement relié aux grilles des transistors haute tension 5 et basse tension 6 pour commander l'état bloqué ou passant de ces transistors, notamment lors du passage d'un mode de fonctionnement à un autre du dispositif 1. En contrôlant individuellement et directement les grilles des transistors, on peut se prémunir des effets transitoires qui pourraient se développer et endommager l'un des transistors. On peut également de la sorte se prémunir d'un fonctionnement non sécurisé du dispositif.

Comme cela est schématiquement représenté par le modèle de transition de la figure 2, le mode de fonctionnement du dispositif 1 est déterminé par le niveau d'un signal d'activation appliqué à la seconde entrée 10 du circuit de commande 8. Lorsque ce signal d'activation présente un premier niveau (par exemple de 5 V), le dispositif de commutation 1 est commandé en fonctionnement normal, c'est-à-dire actif.

Dans ce mode de fonctionnement, le circuit de commande 8 applique sur la deuxième borne 7 un signal de commande présentant une tension supérieure à la tension seuil du transistor basse tension 6 de manière à le rendre passant. Dans le même temps, le circuit de commande 8 transmet le signal de commutation, qui est appliqué à la première entrée 9 dudit circuit de commande 8, à la première borne 3, de manière à piloter en commutation le transistor haute tension 5, via le circuit d'attaque 4. Dans ce mode de fonctionnement, les sources de tension d'alimentation électrique VDR+, VDR- des éléments actifs du dispositif 1 sont commandées par le circuit de commande 8 pour être en fonctionnement, c'est-à-dire pour qu'elles délivrent une première et une seconde tension égale, à 10% près, à leurs tensions de consigne.

Dans ce mode de fonctionnement également, un circuit de protection 11 (dont la description sera détaillée plus loin) est inactif, c'est-à-dire qu'il est commandé pour être ouvert.

Lorsque le signal d'activation présente un second niveau, différent du premier (par exemple 0 V), le dispositif 1 est en mode de fonctionnement inactif (« stand-by »). Dans ce mode de fonctionnement, le circuit de commande 8 applique sur la deuxième borne 7 un signal de commande présentant une tension inférieure à la tension seuil du transistor basse tension 6 de manière à le rendre bloquant. Dans le même temps, le circuit de commande 8 applique une tension de blocage nulle ou suffisamment faible à la première borne 3 de manière à rendre bloquant, via le circuit d'attaque 4, le transistor haute tension 5. Dans ce mode de fonctionnement inactif, les sources de tension assurant l'alimentation électrique des éléments actifs du dispositif, et notamment l'alimentation du circuit d'attaque 4, sont commandées par le circuit de commande pour être éteintes. A cet effet, et comme indiqué précédemment, le circuit de commande 8 est relié aux première et deuxième sources d'alimentation électrique VDR+ et VDR-(figure 1), pour commander leurs mises en fonctionnement et leurs extinctions. Cette liaison peut prendre la forme d'un bus de communication reliant certaines sources de tension d'alimentation du dispositif 1, telles que les première et deuxième sources VDR+ ou VDR- du circuit d'attaque 4. Ce bus de communication peut également être employé pour activer d'autres fonctionnalités du circuit d'attaque 4 comme cela sera exposé dans le détail dans la suite de cet exposé.

L'activation du dispositif de commutation 1, c'est-à-dire le passage du mode inactif au mode actif, est détectée par le circuit de commande 8 sur un front montant du signal d'activation. Sur ce front montant, le circuit de commande 8 enclenche l'établissement des sources de tension assurant l'alimentation des éléments actifs du dispositif.

Lorsque celles-ci sont bien établies, le circuit de commande 8 place le dispositif 1 en mode de fonctionnement actif tel que cela a été décrit précédemment. Si ces tensions ne peuvent s'établir correctement, le circuit de commande 8 maintient le dispositif 1 en mode inactif, c'est-à-dire que le transistor haute tension 5 et le transistor basse tension 6 sont tous deux commandés pour présenter un état bloqué. Le circuit de commande 8 signale éventuellement ce dysfonctionnement par l'intermédiaire d'un signal additionnel (non représenté sur la figure 1).

Par « établir correctement les sources de tension », on signifie que celles-ci délivrent une tension égale à 10% près leurs tensions de consigne. Le circuit de commande 8 est relié aux sources de tension VDR+, VDR- ce qui lui permet de recevoir les tensions effectivement délivrées par ces sources et de les comparer aux tensions de consignes. Le circuit de commande est ainsi apte à détecter leur bon état de fonctionnement.

La désactivation du dispositif de commutation 1, c'est-à-dire le passage du mode actif au mode inactif, est détectée par le circuit de commande 8 sur un front descendant du signal d'activation. Sur ce front descendant, le circuit de commande 8 enclenche, dans une première étape, l'application d'une tension de blocage nulle ou suffisamment faible sur la première borne 3 pour rendre bloquant le transistor haute tension 5, via le circuit d'attaque 4. Puis, dans une seconde étape, le circuit de commande 8 applique sur la deuxième borne 7 une tension conduisant à rendre le transistor basse tension 6 bloquant. Le circuit de commande 8 commande alors l'extinction des sources de tension assurant l'alimentation des éléments actifs du dispositif 1 et donc les tensions délivrées par les première et deuxième sources VDR+, VDR- ne peuvent plus être garanties.

La désactivation du dispositif de commutation 1 peut être provoquée par d'autres évènements qu'un front descendant du signal d'activation. Il peut par exemple s'agir d'un évènement indiquant une défaillance ou d'un événement susceptible de provoquer une défaillance du dispositif de commutation. A titre d'exemple, si, lorsque le dispositif de commutation 1 est en mode actif, le circuit de commande 8 détecte que la première tension et/ou la deuxième tension délivrée par les sources de tensions VDR+, VDR- du circuit d'attaque 4 s'écartent à plus de 10% de leurs valeurs de consigne, il peut provoquer le passage à l'état inactif du dispositif 1.

L'activation et la désactivation du dispositif 1 selon l'invention permet de limiter voire d'éliminer l'apparition de tensions transitoires ou de chemins de courants transitoires entre les bornes de commutation du dispositif 1, du fait de la prise en compte de l'établissement correct des tensions issues des première et deuxième sources de tension VDR+ et VDR-, lors de l'activation, et du fait de la mise en mode bloquant du transistor haute tension préalablement à l'extinction des sources de tensions, lors de la désactivation.

En alternative à ce qui a été présenté, on peut prévoir que l'activation du dispositif de commutation 1 se réalise sur un front descendant du signal de commande, et que sa désactivation se réalise sur un front montant de ce signal.

Comme on l'a vu en préambule de cette demande, dans le mode inactif du dispositif de commutation 1, la grille du transistor haute tension 5 présente une tension flottante, qui peut être affectée, par effet de couplage, par la tension se développant sur le drain du transistor haute tension 5. Ce transistor peut de manière non contrôlée passer alors d'un état bloqué à un état passant, ce qui peut endommager le dispositif de commutation 1, et notamment le transistor basse tension 6.

Afin de prévenir ce phénomène, le dispositif de commutation 1 comprend, selon un autre aspect de l'invention, un circuit de protection 11 normalement passant et électriquement relié entre la seconde borne 7 et la grille du transistor haute tension 5.

Le circuit de protection 11 a pour fonction de rendre et maintenir bloquant le transistor haute tension 5 lorsque le circuit d'attaque 4 n'est pas électriquement alimenté. Le circuit de protection 11 est normalement passant, il ne nécessite pas d'être électriquement alimenté pour assurer sa fonction, et il peut fonctionner même en l'absence des tensions d'alimentation du dispositif 1, lorsque celui-ci est désactivé. Lorsque le dispositif de commutation est en mode de fonctionnement actif, le circuit de protection est commandé pour être désactivé. Il constitue donc un circuit de protection à sécurité intégré (« fail safe » selon la terminologie anglo-saxonne usuellement employée).

Lorsque le dispositif de commutation 1 est inactif, la sortie du circuit d'attaque 4 présente une haute impédance. La tension de grille du transistor haute tension 5 est donc flottante et non contrôlée. Le circuit de protection 11 vise donc à placer cette tension à une valeur déterminée, assurant le blocage du transistor haute tension 5. On évite de la sorte d'appliquer toute la tension du générateur G aux bornes du transistor basse tension 6, ce qui pourrait l'endommager.

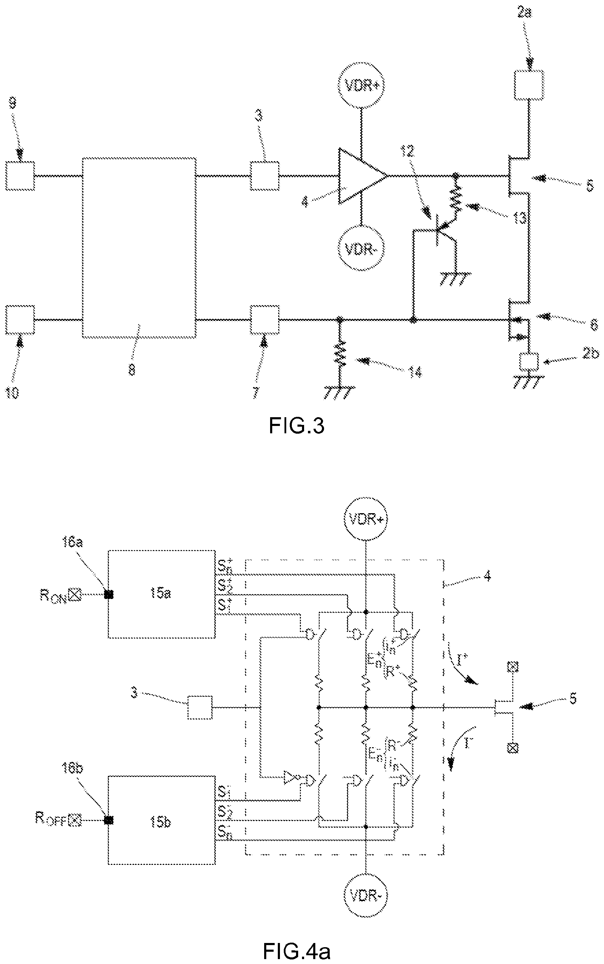

La figure 3 présente un exemple particulier de mise en œuvre de cet aspect de l'invention. On reconnaît sur cette figure les deux bornes de commutation 2a, 2b, le transistor haute tension 5, le transistor basse tension 6, le circuit d'attaque 4, le circuit de commande 8 et les deux bornes 3, 7 déjà décrits en relation avec la description générale de l'invention.

Le circuit de protection 11 est formé d'un transistor bipolaire PNP 12 et d'une résistance 13 placée dans l'émetteur du transistor bipolaire 12. La base du transistor bipolaire 12 est électriquement reliée à la seconde borne 7. Le collecteur est placé à la masse du dispositif 1 et la résistance électrique 13 connectée à la grille du transistor haute tension 5.

Le circuit de protection comprend en outre, entre la seconde borne d'entrée 7 et la masse du dispositif 1, une seconde résistance 14.

Lorsque le signal de commande du dispositif 1 est supérieur à la tension seuil du transistor basse tension 6, et donc lorsque le dispositif de commutation 1 est en mode de fonctionnement actif, le transistor bipolaire 12 est ouvert et le circuit de protection 11 n'a aucune influence sur le fonctionnement du transistor haute tension 5 et donc du dispositif de commutation 1 dans son ensemble.

Plus précisément, cette condition est respectée lorsque la tension de la base du transistor bipolaire 12 est supérieure à la tension de son émetteur. La tension de la base correspond à la commande de la grille du transistor basse tension 6. La tension de l'émetteur est alternativement égale à la première et à la seconde tension délivrée par les sources de tension VDR+, VDR- du circuit d'attaque. Pour qu'effectivement le transistor bipolaire 12 soit ouvert en fonctionnement normal du dispositif, on choisit la tension de commande du transistor basse tension 6 pour qu'elle soit supérieure à la première tension délivrée par la source de tension VDR+ du circuit d'attaque 4.

Lorsqu'au contraire, le signal de commande du dispositif de commutation 1 est inférieur à la tension seuil du transistor basse tension 6, et donc lorsque le dispositif de commutation 1 est en mode de fonctionnement inactif, le transistor bipolaire 12 est fermé sur la première résistance 13 placée à la masse. Le circuit qui se forme alors conduit à placer la tension de grille du transistor haute tension 5 à une tension proche de 0V. La source du transistor haute tension 5 est placée, lorsque le transistor basse tension 6 est en mode bloqué, sensiblement à la tension d'avalanche de ce transistor basse tension (qui peut être de l'ordre de 30V). On applique donc une tension entre la grille et la source du transistor haute tension 5 inférieure à sa tension seuil, assurant son état bloquant avec certitude.

Bien que l'on ait présenté un dispositif de commutation 1 combinant un circuit de protection 11 et un circuit de commande 8, chacun de ces éléments peut être exploité séparément dans des dispositifs de commutation présentant une architecture différente que celle qui vient d'être décrite.

Dans un mode de réalisation particulier d'un dispositif de commutation 1 conforme à l'invention, le circuit d'attaque 4 présente une configuration adaptable, c'est-à-dire qu'il peut être configuré pour piloter différents types de transistors haute tension, présentant des tensions seuil différentes.

Rappelons que les transistors haute tension peuvent présenter des tensions seuil différentes, ces différences pouvant trouver leurs origines dans la spécification même du produit ou dans la variabilité inévitable de leur procédé de fabrication.

Un circuit d'attaque 4 à configuration adaptable présente l'avantage d'être utilisable quel que soit le type de transistor haute tension choisi pour être incorporé dans le dispositif de commutation 1. Les première et deuxième sources de tension VDR+, VDR- peuvent être programmées pour fournir des valeurs de première et deuxième tensions adaptées au type de transistor haute tension 5 choisi. La grille des transistors haute tension étant réputée fragile, le circuit d'attaque 4 à configuration adaptable présente l'avantage de pouvoir être appairer avec le transistor haute tension 5 choisi, limitant ainsi les risques d'endommagement dudit transistor, liés à des tensions transitoires. On peut ainsi configurer les première et deuxième sources de tension VDR+, VDR- du circuit d'attaque 4 pour que les tensions qu'elles génèrent présente une marge suffisante avec la tension seuil particulière du transistor choisi.

La programmation des niveaux de tensions de la première source VDR+ et de la deuxième source VDR- est avantageusement réalisée par des mots binaires, stockées dans des cellules mémoires de chaque source de tension VDR+, VDR-.

Préférentiellement, au moins trois bits (soit 8 niveaux) sont utilisés pour programmer avec suffisamment de résolution les valeurs de la deuxième tension de la deuxième source VDR-. Ces valeurs seront par exemple comprises dans la plage [-5V ; -15V], qui correspond à une plage de deuxièmes tensions aptes à bloquer différents types de transistors haute tension, de tensions seuils par exemple comprises dans cette plage (D-mode).

De même, au moins trois bits pourront être utilisés pour programmer avec suffisamment de résolution les valeurs de la première tension de la première source VDR+. Ces valeurs pourront par exemple être comprises dans la plage [+2V ; +8V], qui correspond à une plage de premières tensions aptes à rendre passants différents types de transistors haute tension.

Alternativement, au moins deux bits (4 niveaux) pourront être utilisés pour programmer avec suffisamment de résolution des valeurs d'excursions en tension par rapport à une première ou à une deuxième tension de référence.

Par exemple, considérant la deuxième source VDR-programmable sur 3 bits (correspondant ici à la tension de référence), les valeurs des premières tensions de la première source VDR+ seront issues de la somme d'une valeur de deuxième tension et d'une valeur d'excursion en tension. Selon une variante la tension de référence pourra être la première tension, et la deuxième tension sera alors définie par la somme de la première tension et d'une valeur d'excursion négative.

En fonction de la valeur de tension et de la résolution en tension souhaitée, on pourra bien-sûr utiliser un nombre moindre de bits ou un plus grand nombre de bits pour la programmation des sources de tensions VDR+, VDR-.

Comme cela a été mentionné préalablement, le circuit de commande 8 est relié au circuit d'attaque 4 par un bus de communication, permettant de configurer chacune des première et deuxième sources de tension VDR+ et VDR- et de sélectionner les niveaux respectivement de la première tension et de la deuxième tension. Les niveaux les plus adaptés, et les mots binaires associés, peuvent être déterminés en fin de fabrication du dispositif 1, par exemple au cours d'une phase de test et de configuration. Les mots binaires correspondant aux niveaux des tensions choisis, peuvent être enregistrés dans une mémoire non volatile du circuit de commande 8. La configuration des première et deuxième sources de tensions VDR+, VDR- du circuit d'attaque 4 peut être réalisée à l'aide du bus de communication, au cours de l'établissement des sources de tension, lors du basculement de l'état inactif à l'état actif du dispositif de commutation 1. Alternativement, les mots binaires correspondant aux niveaux de tensions choisis peuvent être enregistrés une fois pour toute dans des mémoires non volatiles des première et deuxième sources de tensions VDR+, VDR- du circuit d'attaque 4 en fin de fabrication du dispositif 1.

Ainsi quelque soit le type et les spécificités du transistor haute tension 5 inclus dans le dispositif de commutation 1, le circuit de commande 8 permet d'adapter au plus juste les première et deuxième tensions qui lui seront appliquées par le circuit d'attaque 4 pour le rendre passant ou bloquant. Cette caractéristique contribue à rendre le dispositif de commutation 1 particulièrement robuste et sécurisé.

Selon un autre mode de réalisation d'un dispositif de commutation 1 conforme à l'invention, le circuit d'attaque 4, relié à la grille du transistor haute tension 5, est configuré pour permettre de contrôler et optimiser le courant de grille injecté, c'est-à-dire « entrant » au niveau de la grille du transistor haute tension 5 pour le rendre passant ; il est également configuré pour permettre de contrôler et optimiser le courant de grille tiré, c'est-à-dire « sortant » de la grille du transistor haute tension 5 pour le rendre bloquant.

Le contrôle et l'optimisation du courant de grille du transistor haute tension 5 vise à limiter la création de parasites électromagnétiques (CEM) et à minimiser les pertes en commutation. En effet, plus l'intensité du courant de grille est élevée, plus le temps de commutation est court ; et plus le temps de commutation est court, moins il y a de pertes de commutation, mais plus il y a de perturbations électromagnétiques.

Il est donc utile de pouvoir contrôler et optimiser les courants de grille entrant et sortant pour établir un fonctionnement optimal tant du point de vue des pertes de commutation, des perturbations électromagnétiques que du point de vue des tensions et courants parasites en phases transitoires. Ce point de fonctionnement optimal n'est pas défini en soi, il peut être lié à l'usage particulier qui sera fait du dispositif de commutation 1. Il est donc intéressant de fournir les moyens permettant à un utilisateur de sélectionner les conditions de fonctionnement optimales du dispositif dans son environnement.

Comme vu précédemment, le circuit d'attaque 4 est alimenté avec une première tension, issue d'une première source VDR+, et avec une deuxième tension, issue d'une deuxième source VDR-.

Pour déterminer l'intensité des courants de grille entrant et sortant, le circuit d'attaque 4 est associé à au moins un module de programmation. Ledit module de programmation pourra être compris dans le circuit d'attaque 4 ou alternativement se trouver à l'extérieur du circuit d'attaque 4 et être connecté à ce dernier.

Avantageusement, le circuit d'attaque 4 est muni ou connecté à un premier et un second module de programmation 15a, 15b. Chaque module de programmation 15a, 15b joue le rôle d'un convertisseur analogique / numérique destiné à convertir une tension analogique en une pluralité de signaux de sélection.

Chaque module de programmation 15a, 15b comporte une borne d'entrée 16a, 16b apte à être connectée à un premier et un second composant passif ; ces composants passifs pourront par exemple être de nature résistive ou capacitive, préférentiellement disposées à l'extérieur du dispositif de commutation 1 pour être accessibles et modifiables par une utilisateur.

De manière avantageuse, le premier composant passif et le second composant passif sont formés par une première résistance externe Rₒₙ et une seconde résistance externe R_{off}. Ces première et seconde résistances peuvent être placées sur le circuit imprimé destiné à intégrer le dispositif de commutation 1. La première résistance Rₒₙ est connectée à la borne d'entrée 16a du premier module de programmation du courant entrant 15a et la seconde résistance R_{off} est connectée à la borne d'entrée 16b du second module de programmation du courant sortant 15b. Les résistances Rₒₙ et R_{off} étant accessibles à l'extérieur du boitier formant le dispositif de commutation 1, par exemple au niveau du circuit imprimé, elles peuvent être choisies librement par l'utilisateur.

En fonction de la valeur de la résistance Rₒₙ, la borne d'entrée 16a du module de programmation 15a étant alimentée par une source de courant, une tension se développe aux bornes de ladite résistance. La valeur de cette tension (analogique) est interprétée par des comparateurs du premier module de programmation 15a et décodée pour établir des signaux de sélection S⁺ₙ en sortie dudit module, qui transmis au circuit d'attaque 4, vont permettre la programmation du courant entrant.

Ce même principe de fonctionnement s'applique au second module de programmation 15b, pour la programmation du courant sortant.

Selon une première option, le circuit d'attaque 4 est configuré pour permettre une programmation discrétisée du courant de grille entrant au niveau de la grille du transistor haute tension 5 et en sortant (figure 4a).

Le circuit d'attaque 4 comprend une pluralité de sources de courant E⁺ₙ, montées en parallèle entre la première source VDR+ et la grille du transistor à haute tension 5 et destinées à gérer le courant de grille entrant I⁺ ; il comprend également une pluralité de sources de courant E⁻ₙ montées en parallèle entre la deuxième source VDR- et la grille du transistor à haute tension 5 et destinées à gérer le courant de grille sortant I⁻.

Chaque source de courant E⁺ₙ (respectivement E⁻ₙ) pourra par exemple comprendre un interrupteur i⁺ₙ (respectivement i⁻ₙ) monté en série avec une résistance R⁺ (respectivement R⁻) placée entre ledit interrupteur et la grille du transistor haute tension 5, comme illustré sur le schéma fonctionnel de la figure 4a. Chaque interrupteur i⁺ₙ (respectivement i⁻ₙ) correspond à une porte logique (« ET ») apte à se fermer en fonction du signal délivré par la borne 3, appliqué à l'entrée du circuit d'attaque 4 et d'un (au moins) signal de sélection S⁺ₙ (respectivement S⁻ₙ).

Ce signal de sélection S⁺ₙ, S⁻ₙ est établi en sortie respectivement du module de programmation du courant entrant 15a et du module de programmation du courant sortant 15b.

Lesdits modules de programmation 15a, 15b peuvent éventuellement être compris dans le circuit de commande 8 (non représenté). Dans ce cas, les signaux de sélection peuvent être communiqué au circuit d'attaque 4 par l'intermédiaire d'un bus de communication. Alternativement, comme évoqué précédemment, les modules de programmation 15a, 15b peuvent être intégrés au circuit d'attaque 4 lui-même.

On expose maintenant le fonctionnement du dispositif de commutation 1 dans cette première option du mode de réalisation. Considérons par exemple que le signal de sélection S⁺₁ est activé ; quand le signal de commutation arrive sur la borne 3, la source de courant E⁺₁ du circuit d'attaque 4 est activée et un courant de grille I⁺₁ entrant est fourni à la grille du transistor haute tension 5. Ce courant I⁺₁ entrant aura une valeur définie par la résistance R⁺ et par la première tension issue de la première source de tension VDR+. Si les signaux S⁺₁ et S⁺₂ avaient été activés, un courant de grille I⁺₁₊₂ de plus forte intensité aurait été fourni à la grille du transistor haute tension 5.

Ainsi, il est possible de contrôler et d'optimiser le courant de grille fourni I⁺ (entrant) à la grille du transistor haute tension 5, par le choix de la première résistance Rₒₙ, accessible à l'extérieur du boitier du dispositif, au niveau du circuit imprimé.

De même, en fonction de la valeur de la seconde résistance R_{off}, un ou plusieurs parmi les différents signaux de sélection S⁻ₙ est(sont) activé(s) en sortie du module de programmation du courant sortant 15b, ce qui permet de moduler également l'intensité du courant sortant de la grille du transistor haute tension 5, lorsque le signal de blocage est envoyé à l'entrée du circuit d'attaque 4 pour passer ledit transistor 5 en état bloqué.

Ainsi, il est possible de contrôler et d'optimiser le courant de grille absorbé I⁻ (sortant), par le choix de la résistance R_{off}, accessible à l'extérieur du boitier du dispositif de commutation 1, au niveau du circuit imprimé.

Selon une variante de cette première option, la programmation des courants entrant et sortant peut être réalisée à partir d'un seul module de programmation 15, comportant une seule borne d'entrée 16 apte à être connectée à la première et la seconde résistance externe Rₒₙ, R_{off} (ou, de manière plus générale, au premier et au second composant passif).

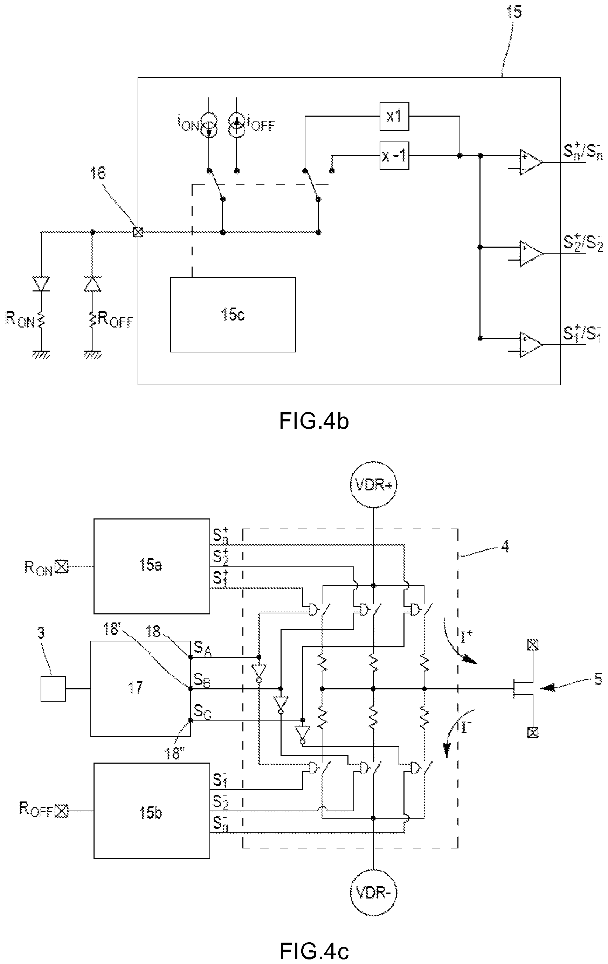

Chaque résistance Rₒₙ, R_{off} est connectée à la borne d'entrée 16 par une diode en série, les deux diodes étant montées en sens inverse (figure 4b).

Dans cette variante, le module de programmation 15 comprend un séquenceur 15c qui va d'abord autoriser la mesure de la première résistance Rₒₙ par injection d'un premier courant iₒₙ, au niveau de la borne d'entrée 16 ; le décodage de cette valeur de résistance par le module de programmation 15 permet alors d'établir les signaux de sélection S⁺ₙ en sortie du module 15 pour le courant entrant. Le séquenceur va ensuite autoriser la mesure de la seconde résistance R_{off} par injection d'un second courant i_{off} de signe opposé au premier courant iₒₙ, au niveau de la borne d'entrée 16 ; le décodage de cette valeur de résistance par le module de programmation 15 permet d'établir les signaux de sélection S⁻ₙ en sortie du module 15 pour le courant sortant.

Le fonctionnement est par ailleurs identique à celui décrit pour la première option.

Selon une deuxième option de ce mode de réalisation, le circuit d'attaque 4 est configuré pour permettre une programmation continue du courant de grille.

Comme dans l'option précédente, des modules de programmation 15'a, 15'b du courant entrant I⁺ et sortant I⁻ sont avantageusement compris dans le circuit d'attaque 4. Alternativement, ils pourront être disposés à l'extérieur et/ou compris dans le circuit de commande 8 ; dans ce cas, les première et deuxième sources de tension pourront être connectées au circuit d'attaque 4 par l'intermédiaire des modules de programmation.

Les modules de programmation du courant entrant 15'a et sortant 15'b sont alimentés par la source de tension VDR+ et comporte chacun une borne d'entrée 16'a, 16'b. Chaque borne 16'a, 16'b est apte à être connectée à une première et une seconde résistance externe au dispositif de commutation 1, référencées Rₒₙ pour la borne d'entrée 16'a du module de programmation du courant entrant 15'a et R_{off} pour la borne d'entrée 16'b du module de programmation du courant sortant 15'b. Comme vu précédemment, les premières et secondes résistances Rₒₙ, R_{off} étant accessibles à l'extérieur du boitier définissant le dispositif de commutation 1, elles peuvent être librement choisies par l'utilisateur. Notons que bien que l'on décrive ici des résistances Rₒₙ, R_{off}, celles-ci pourraient être remplacées par deux composants passifs de nature différente, susceptibles de remplir la même fonction.

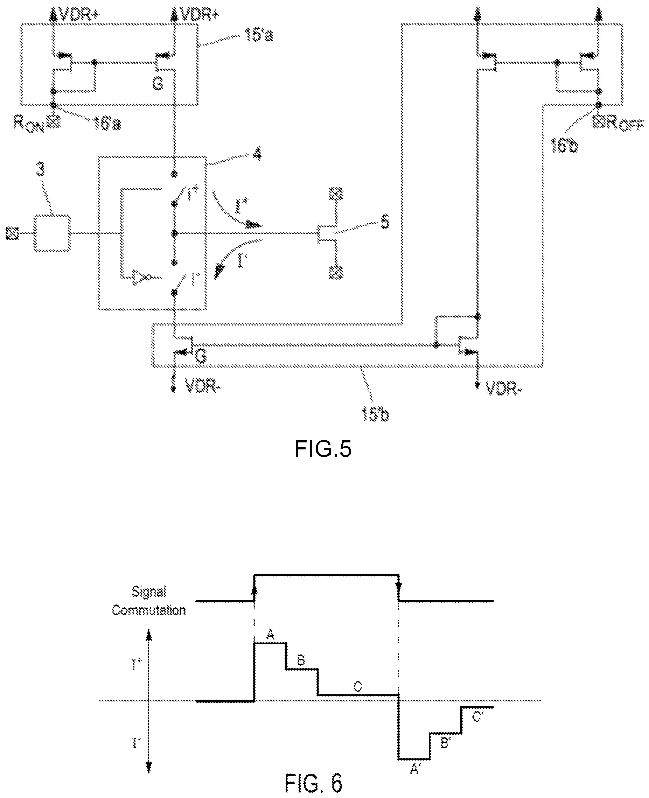

Le circuit d'attaque 4 comprend au moins un interrupteur i⁺ entre la première source VDR+ et la grille du transistor à haute tension 5, destiné à gérer le courant de grille entrant I⁺ ; il comprend également au moins un interrupteur i⁻ entre la deuxième source VDR- et la grille du transistor à haute tension 5, destiné à gérer le courant de grille sortant I⁻, comme illustré sur le schéma fonctionnel de la figure 5.

Au niveau du module de programmation du courant entrant 15'a, un courant d'intensité donnée va s'établir en fonction de la valeur de la première résistance Rₒₙ, et être interprété par un composant de type miroir de courant de gain G inclus dans le module de programmation 15'a. Le rapport (gain = G) du miroir de courant va contribuer à ajuster la valeur du courant I⁺ en sortie du module de programmation du courant entrant 15'a.

Lorsque le signal de commutation est appliqué sur la borne 3, en entrée du circuit d'attaque 4, l'interrupteur i⁺ devient passant et injecte le courant I⁺ à la grille du transistor haute tension 5.

Ainsi, il est possible de contrôler et d'optimiser le courant de grille fourni I⁺ (entrant) à la grille, par le choix de la résistance Rₒₙ, accessible à l'extérieur du boitier du dispositif, au niveau du circuit imprimé.

Il en est de même pour le courant de grille tiré I⁻ (sortant), contrôlé, via le module de programmation du courant sortant 15'b, par le choix de la seconde résistance R_{off}, accessible à l'extérieur du boitier du dispositif de commutation 1, par exemple au niveau du circuit imprimé. Le miroir de courant de gain G est lui référencé à VDR-.

Dans les deux options qui viennent d'être présentés, les champs électromagnétiques émis pendant le fonctionnement du dispositif de commutation 1 peuvent affecter le fonctionnement des modules de programmation 15a, 15'a, 15b, 15'b. Ils peuvent notamment conduire à perturber la mesure de la tension se développant aux bornes de la première et de la seconde résistance Rₒₙ et R_{off}, ce qui pourrait entrainer la génération d'un courant entrant et sortant non adapté. Pour éviter ce problème, les modules de programmation sont configurés pour établir et figer l'intensité de ces courants au cours de l'étape d'établissement des première et deuxième sources de tension, lors du passage de l'état actif à l'état inactif du dispositif de commutation 1.

Avantageusement, pour l'une et l'autre des options précédemment décrites dans ce mode de réalisation de l'invention, le dispositif de commutation 1 permet également de contrôler l'évolution temporelle du courant de grille entrant et sortant au niveau de la grille du transistor haute tension 5, suite à la détection d'un front montant ou descendant du signal de commutation.

Différents niveaux de courants de grille (entrant et/ou sortant) peuvent être établis temporellement, comme illustré par exemple sur la figure 6.

Sur un front montant du signal de commutation, le courant de grille entrant I⁺ est injecté d'abord à un niveau élevé A, pour atteindre rapidement une valeur proche de la tension de seuil et réduire ainsi le temps de commutation à l'état passant. Le courant de grille I⁺ est ensuite réduit à un niveau intermédiaire B, pour atteindre une tension de grille supérieure à la tension de seuil, sensiblement égale à la première tension issue de la première source VDR+, apte à maintenir le transistor 5 dans l'état passant. Enfin, le courant de grille est encore réduit à un niveau bas C, pour maintenir le transistor haute tension 5 dans l'état passant.

Le courant de grille sortant I⁻ suit un comportement similaire. Sur un front descendant du signal de commutation, le courant de grille est tiré (courant négatif) d'abord à un niveau élevé A' pour une décharge rapide (et un temps de commutation court), puis à un niveau intermédiaire B' pour amener la tension de grille à une valeur sensiblement égale à la deuxième tension issue de la deuxième source VDR- (apte à maintenir le transistor 5 dans l'état bloquant) ; enfin, le courant de grille I⁻ est tiré à un niveau bas C', pour maintenir le transistor haute tension 5 dans l'état bloquant.

Pour contrôler l'évolution transitoire du courant de grille entrant ou sortant, le dispositif de commutation 1 selon ce mode de mise en œuvre de l'invention comprend un module de génération de signaux transitoires 17 entre la première borne 3 et le circuit d'attaque 4, comme illustré sur la figure 4c. Ce module de génération de signaux transitoires 17 comprend une entrée reliée à la première borne 3 et une pluralité de sorties 18, 18', 18" électriquement connectées au(x) interrupteur(s) du circuit d'attaque 4. Les signaux S_{A}, S_{B} et S_{C} issus des sorties 18, 18', 18" jouent le rôle de signaux de commutation ou de blocage pour le circuit d'attaque 4, en sortie duquel seront générés les différents niveaux A, B, C ou A', B', C', de courants de grille entrants I⁺ ou sortants I⁻.

Le module de génération de signaux transitoires 17 pourra être compris dans le circuit de commande 8 ou dans le circuit d'attaque 4.

Le dispositif de commutation 1 selon les différents modes de réalisation et options précédemment décrits peut passer d'un mode inactif à un mode actif (et inversement) sans endommager les transistors qui le composent ; son fonctionnement limite également les risques d'endommagement des transistors qui le composent, en mode actif, inactif ou lors des phases transitoires de passage d'un mode à l'autre.

Bien entendu l'invention n'est pas limitée aux modes de mise en œuvre décrits et on peut y apporter des variantes de réalisation sans sortir du cadre de l'invention tel que défini par les revendications.

## Revendications

1. Dispositif de commutation (1) d'un circuit de puissance comprenant :
- deux bornes de commutation (2a, 2b) ;
- un transistor haute tension (5) en mode déplétion et un transistor basse tension en mode enrichissement (6) disposés en série entre les deux bornes de commutation (2a, 2b);
le dispositif (1) étant **caractérisé en ce qu'**il comprend :
- un circuit de commande (8) présentant une première entrée (9) pour recevoir un signal de commutation et une seconde entrée (10) pour recevoir un signal d'activation du dispositif (1), le circuit de commande (8) étant configuré pour placer le dispositif de commutation (1) :
▪ dans un état inactif, lorsque le signal d'activation présente un premier niveau, dans lequel le transistor basse tension (6) et le transistor haute tension (5) sont chacun rendus bloquants ;
▪ et dans un état actif lorsque le signal d'activation présente un second niveau différent du premier, dans lequel le transistor basse tension (6) est rendu passant et le signal de commutation appliqué à la grille du transistor haute tension (5) ;
- un circuit d'attaque (4) pour appliquer le signal de commutation à la grille du transistor haute tension (5), le circuit d'attaque (4) étant alimenté avec une première tension issue d'une première source de tension (VDR+) et avec une deuxième tension issue d'une deuxième source de tension (VDR-), la première et la deuxième tension étant respectivement supérieure et inférieure à la tension de seuil du transistor haute tension (5) ;
- au moins un module de programmation (15, 15a, 15'a, 15b, 15'b) associé au circuit d'attaque (4), ce dernier étant configuré pour permettre une programmation du courant entrant (I⁺), destiné à être injecté à la grille du transistor haute tension (5), et du courant sortant (I⁻), destiné à être tiré de ladite grille ; le module de programmation étant connectable à un premier et un second composant passif, pour programmer respectivement le courant entrant (I⁺) et le courant sortant (I⁻).

2. Dispositif de commutation (1) d'un circuit de puissance selon la revendication précédente, dans lequel le au moins un module de programmation (15, 15a, 15'a, 15b, 15'b) est compris dans le circuit d'attaque (4).

3. Dispositif de commutation (1) d'un circuit de puissance selon la revendication 1, dans lequel le au moins un module de programmation (15, 15a, 15'a, 15b, 15'b) est extérieur au circuit d'attaque (4) et connecté à celui-ci.

4. Dispositif de commutation (1) d'un circuit de puissance selon l'une des revendications précédentes, comprenant deux modules de programmation (15a, 15'a, 15b, 15'b), l'un connectable au premier composant passif et destiné à programmer le courant entrant (I⁺), et l'autre connectable au second composant passif et destiné à programmer le courant sortant (I⁻).

5. Dispositif de commutation (1) d'un circuit de puissance selon l'une des revendications précédentes, dans lequel le premier et le second composant passif sont des résistances (Rₒₙ, R_{off}).

6. Dispositif de commutation (1) d'un circuit de puissance selon l'une des revendications précédentes, dans lequel les première et deuxième sources de tension (VDR+, VDR-) sont programmables.

7. Dispositif de commutation (1) d'un circuit de puissance selon l'une des revendications précédentes, comprenant un module générateur de signaux transitoires (17) connecté au circuit d'attaque (4) configuré pour contrôler l'évolution transitoire du courant de grille entrant (I⁺) et sortant (I⁻ ) au niveau de la grille du transistor haute tension (5).

## Patentansprüche

1. Schaltvorrichtung (1) einer Leistungsschaltung, umfassend:
- zwei Schaltklemmen (2a, 2b);
- einen Hochspannungstransistor (5) im Verarmungsmodus und einen Niederspannungstransistor im Anreicherungsmodus (6), die in Reihe zwischen den beiden Schaltklemmen (2a, 2b) angeordnet sind;
wobei die Vorrichtung (1) **dadurch gekennzeichnet ist, dass** sie umfasst:
- eine Steuerschaltung (8) mit einem ersten Eingang (9) zum Empfangen eines Schaltsignals und einem zweiten Eingang (10) zum Empfangen eines Aktivierungssignals von der Vorrichtung (1), wobei die Steuerschaltung (8) derart konfiguriert ist, dass die Schaltvorrichtung (1):
▪ in einen inaktiven Zustand versetzt wird, wenn das Aktivierungssignal einen ersten Pegel aufweist, in dem der Niederspannungstransistor (6) und der Hochspannungstransistor (5) jeweils ausgeschaltet sind;
▪ und in einen aktiven Zustand versetzt wird, wenn das Aktivierungssignal einen zweiten Pegel aufweist, der sich von dem ersten unterscheidet, in dem der Niederspannungstransistor (6) eingeschaltet und das Schaltsignal an das Gate des Hochspannungstransistors (5) angelegt wird;
- eine Treiberschaltung (4) zum Anlegen des Schaltsignals an das Gate des Hochspannungstransistors (5), wobei die Treiberschaltung (4) mit einer ersten Spannung von einer ersten Spannungsquelle (VDR+) und mit einer zweiten Spannung von einer zweiten Spannungsquelle (VDR-) versorgt wird, wobei die erste und die zweite Spannung jeweils höher und niedriger als die Schwellenspannung des Hochspannungstransistors (5) sind;
- mindestens ein Programmiermodul (15, 15a, 15'a, 15b, 15'b), das der Treiberschaltung (4) zugeordnet ist, wobei letztere so konfiguriert ist, dass sie eine Programmierung des Eingangsstroms (I⁺) ermöglicht, der in das Gate des Hochspannungstransistors (5) eingespeist werden soll, und des Ausgangsstroms (I⁻), der aus diesem Gate herausgezogen werden soll; wobei das Programmiermodul mit einer ersten und einer zweiten passiven Komponente verbunden werden kann, um den Eingangsstrom (I⁺) bzw. den Ausgangsstrom (I⁻) zu programmieren.

2. Schaltvorrichtung (1) einer Leistungsschaltung nach dem vorhergehenden Anspruch, bei dem das mindestens eine Programmiermodul (15, 15a, 15'a, 15b, 15'b) in der Treiberschaltung (4) enthalten ist.

3. Schaltvorrichtung (1) einer Leistungsschaltung nach Anspruch 1, bei der sich das mindestens eine Programmiermodul (15, 15a, 15'a, 15b, 15'b) außerhalb der Treiberschaltung (4) befindet und mit dieser verbunden ist.

4. Schaltvorrichtung (1) einer Leistungsschaltung nach einem der vorhergehenden Ansprüche, umfassend zwei Programmiermodule (15a, 15'a, 15b, 15'b), wobei das eine mit der ersten passiven Komponente verbindbar und zum Programmieren des Eingangsstroms (I⁺) vorgesehen ist, und das andere mit der zweiten passiven Komponente verbindbar und zum Programmieren des Ausgangsstroms (I⁻) vorgesehen ist.

5. Schaltvorrichtung (1) einer Leistungsschaltung nach einem der vorhergehenden Ansprüche, bei der die erste und die zweite passive Komponente Widerstände (Rₒₙ, R_{off}) sind.

6. Schaltvorrichtung (1) einer Leistungsschaltung nach einem der vorhergehenden Ansprüche, bei der die erste und die zweite Spannungsquelle (VDR+, VDR-) programmierbar sind.

7. Schaltvorrichtung (1) einer Leistungsschaltung gemäß einem der vorhergehenden Ansprüche, umfassend ein Transientensignalgeneratormodul (17), das mit der Treiberschaltung (4) verbunden ist, die konfiguriert ist, um die transiente Entwicklung des Eingangs- (I⁺) und Ausgangs- (I⁻) Gate-Stroms am Gate des Hochspannungstransistors (5) zu steuern.

## Claims

1. Switching device (1) of a power circuit comprising:
- two switching terminals (2a, 2b);
- a high-voltage depletion mode transistor (5) and a low-voltage enhancement mode transistor (6) arranged in series between the two switching terminals (2a, 2b);
the device (1) being **characterized in that** it comprises:
- a control circuit (8) having a first input (9) for receiving a switching signal and a second input (10) for receiving an activation signal from the device (1), the control circuit (8) being designed to put the switching device (1):
▪ in an inactive state when the activation signal has a first level, in which the low-voltage transistor (6) and the high-voltage transistor (5) are each turned off;
▪ and in an active state when the activation signal has a second level, which is different from the first, in which the low-voltage transistor (6) is turned on and the switching signal applied to the gate of the high-voltage transistor (5);
- a driver circuit (4) for applying the switching signal to the gate of the high-voltage transistor (5), the driver circuit (4) being supplied with a first voltage from a first voltage source (VDR+) and with a second voltage from a second voltage source (VDR-), the first and the second voltage being higher and lower, respectively, than the threshold voltage of the high-voltage transistor (5);
- at least one programming module (15, 15a, 15'a, 15b, 15'b) associated with the driver circuit (4), said module being designed to allow programming of the incoming current (I⁺) intended to be injected into the gate of the high-voltage transistor (5), and of the outgoing current (I⁻) intended to be drawn from said gate; it being possible for the programming module to be connected to a first and a second passive component for programming the incoming current (I⁺) and the outgoing current (I⁻), respectively.

2. Switching device (1) of a power circuit according to the preceding claim, wherein the at least one programming module (15, 15a, 15'a, 15b, 15'b) is included in the driver circuit (4).

3. Switching device (1) of a power circuit according to claim 1, wherein the at least one programming module (15, 15a, 15'a, 15b, 15'b) is external to the driver circuit (4) and connected thereto.

4. Switching device (1) of a power circuit according to any of the preceding claims, comprising two programming modules (15a, 15'a, 15b, 15'b), one which can be connected to the first passive component and is intended to program the incoming current (I⁺), and the other which can be connected to the second passive component and is intended to program the outgoing current (I⁻).

5. Switching device (1) of a power circuit according to any of the preceding claims, wherein the first and the second passive component are resistors (Rₒₙ, R_{off}).

6. Switching device (1) of a power circuit according to any of the preceding claims, wherein the first and second voltage sources (VDR+, VDR-) are programmable.

7. Switching device (1) of a power circuit according to any of the preceding claims, comprising a transient signal-generating module (17) connected to the driver circuit (4) designed to control the transient evolution of the incoming (I⁺) and outgoing (I⁻) gate current at the gate of the high-voltage transistor (5).
